# EUROPEAN PATENT APPLICATION

(11) **EP 4 708 517 A1**
(43) Date of publication of application: **11.03.2026**
(21) Application number: 25199766.4
(22) Date of filing: 02.09.2025
(51) Int. Cl.: H01M 50/258, H01M 50/569, H01M 10/48, H01M 50/503, H01M 50/507

(54) **SENSING ASSEMBLY AND MANUFACTURING METHOD OF BATTERY CELL STACK**

(30) Priority: 03.09.2024 KR 20240119233
(71) Applicant: Hyundai Mobis Co., Ltd., Gangnam-gu Seoul 06141 (KR)
(72) Inventor: JANG, Jae Young, Gyeonggi-do 16891 (KR)
(74) Representative: Vossius & Partner Patentanwälte Rechtsanwälte mbB

(57) **Abstract**

A sensing assembly includes a plurality of busbars and a plurality of sensing frames arranged along a first direction to support the plurality of busbars. The sensing frames includes a middle sensing frame and an outer sensing frame disposed on a first side of the middle sensing frame along the first direction. The middle sensing frame includes: a first peripheral surface facing toward one side in the first direction; a second peripheral surface disposed on an opposite side to the first peripheral surface and facing toward an opposite side in the first direction; a support surface connected with the second peripheral surface and facing toward one side in a second direction crossing the first direction; a guide protrusion protruding from the first peripheral surface toward the one side in the first direction; and a guide groove disposed where the support surface and the second peripheral surface are connected.

## Description

### CROSS-REFERENCE TO RELATED APPLICATION

This application claims the benefit of priority to Korean Patent Application No. 10-2024-0119233, filed in the Korean Intellectual Property Office on September 03, 2024, the entire contents of which are incorporated herein by reference.

### TECHNICAL FIELD

The present disclosure relates to a sensing assembly and a method for manufacturing a battery cell stack.

### BACKGROUND

In recent years, research and development on electric vehicles, which are environmentally-friendly vehicles, has been emphasized as crisis awareness of environments and oil resource depletion has increased.

An electric vehicle may include a battery pack including battery cells. The battery pack may include the battery cells and a battery housing supporting the battery cells, and the electric vehicle may be driven using the batter cells as a power source.

A battery cell stack may include a plurality of battery cells and a sensing assembly including busbars electrically connected with the plurality of battery cells to sense the voltages of the plurality of battery cells.

Meanwhile, there is a growing need for a length-adjustable sensing assembly to change the capacity of the battery cells when the battery cell stack is mounted in the battery housing.

### SUMMARY

The present disclosure has been made to solve the above-mentioned problems occurring in the prior art while advantages achieved by the prior art are maintained intact.

An aspect of the present disclosure provides a length-adjustable sensing assembly and a method for manufacturing a battery cell stack.

The technical problems to be solved by the present disclosure are not limited to the aforementioned problems, and any other technical problems not mentioned herein will be clearly understood from the following description by those skilled in the art to which the present disclosure pertains.

According to an aspect of the present disclosure, a sensing assembly includes a plurality of busbars and a plurality of sensing frames arranged along a first direction and configured to support the plurality of busbars. The sensing frame include a middle sensing frame and an outer sensing frame disposed on a first side of the middle sensing frame along the first direction. The middle sensing frame includes a first peripheral surface that faces toward one side in the first direction, a second peripheral surface that is disposed on an opposite side to the first peripheral surface and that faces toward an opposite side in the first direction, a support surface that is connected with the second peripheral surface and that faces toward one side in a second direction crossing the first direction, a guide protrusion that protrudes from the first peripheral surface toward the one side in the first direction, and a guide groove disposed on an area where the support surface and the second peripheral surface are connected, the guide groove being open toward the opposite side in the first direction and the one side in the second direction.

The middle sensing frame may include a first middle sensing frame and a second middle sensing frame disposed side by side along the first direction, and a guide protrusion of the first middle sensing frame may be inserted into a guide groove of the second middle sensing frame.

The middle sensing frame may further include a first side surface that faces toward one side in a third direction crossing the first direction and the second direction, a first seating protrusion including a first seating area that extends from the first side surface toward the one side in the first direction and a first insertion area that protrudes from the first seating area toward an opposite side in the third direction, and a first seating groove disposed on an opposite area of the first side surface.

The middle sensing frame may include a first middle sensing frame and a second middle sensing frame disposed side by side along the first direction, and a first seating protrusion of the first middle sensing frame may be seated in a first seating groove of the second middle sensing frame.

The first side surface may include a first base area to which the first seating protrusion is connected and a first recessed area that is recessed from the first base area toward the opposite side in the third direction and that includes the first seating groove disposed thereon.

The middle sensing frame may further include a second side surface that is disposed parallel to the first side surface and that faces toward the opposite side in the third direction, a second seating protrusion including a second seating area that extends from the second side surface toward the one side in the first direction and a second insertion area that protrudes from the second seating area toward the one side in the third direction, and a second seating groove disposed on an opposite area of the second side surface.

The middle sensing frame may include a first middle sensing frame and a second middle sensing frame disposed side by side along the first direction, and a second seating protrusion of the first middle sensing frame may be seated in a second seating groove of the second middle sensing frame.

The second side surface may include a second base area to which the second seating protrusion is connected and a second recessed area that is recessed from the second base area toward the one side in the third direction and that includes the second seating groove disposed thereon.

The outer sensing frame may include an outer guide groove into which the guide protrusion is inserted.

The outer sensing frame may include a first outer seating groove in which the first seating protrusion is seated and a second outer seating groove in which the second seating protrusion is seated.

According to another aspect of the present disclosure, a method for manufacturing a battery cell stack includes a busbar assembly operation of preparing a plurality of unit sensing assemblies in which a busbar is assembled to a sensing frame, a sensing frame assembly operation of coupling unit sensing assemblies adjacent to each other in a first direction among the plurality of unit sensing assemblies after the busbar assembly operation, a sensing line fixing operation of manufacturing a sensing assembly by fixing a sensing line to the plurality of unit sensing assemblies after the sensing frame assembly operation, and a sensing assembly seating operation of seating the sensing assembly on stacked battery cells after the sensing line fixing operation.

### BRIEF DESCRIPTION OF THE DRAWINGS

The above and other objects, features and advantages of the present disclosure will be more apparent from the following detailed description taken in conjunction with the accompanying drawings:
FIG. 1 is a perspective view of a battery cell stack according to an embodiment of the present disclosure;
FIG. 2 is a perspective view of an outer unit sensing assembly of a sensing assembly according to an embodiment of the present disclosure;
FIG. 3 is a perspective view of a middle unit sensing assembly of the sensing assembly according to an embodiment of the present disclosure;
FIG. 4 is a plan view of the sensing assembly according to an embodiment of the present disclosure;
FIG. 5 is a view of a first middle sensing frame and a second middle sensing frame according to an embodiment of the present disclosure;
FIG. 6 is a view illustrating the first middle sensing frame and the second middle sensing frame coupled to each other according to an embodiment of the present disclosure;
FIG. 7 is a flowchart illustrating a method for manufacturing the battery cell stack according to an embodiment of the present disclosure;
FIG. 8 is a perspective view of a sensing line, bus bars, and a sensing frame for a sensing line fixing operation illustrated in FIG. 7; and
FIG. 9 is a perspective view of battery cells, end plates, and sensing assemblies for a sensing assembly seating operation illustrated in FIG. 7.

### DETAILED DESCRIPTION

Hereinafter, some embodiments of the present disclosure will be described in detail with reference to the exemplary drawings. In adding the reference numerals to the components of each drawing, it should be noted that the identical or equivalent component is designated by the identical numeral even when they are displayed on other drawings. Further, in describing the embodiment of the present disclosure, a detailed description of well-known features or functions will be ruled out in order not to unnecessarily obscure the gist of the present disclosure.

In this specification, a first direction D1, a second direction D2, and a third direction D3 may be directions perpendicular to one another.

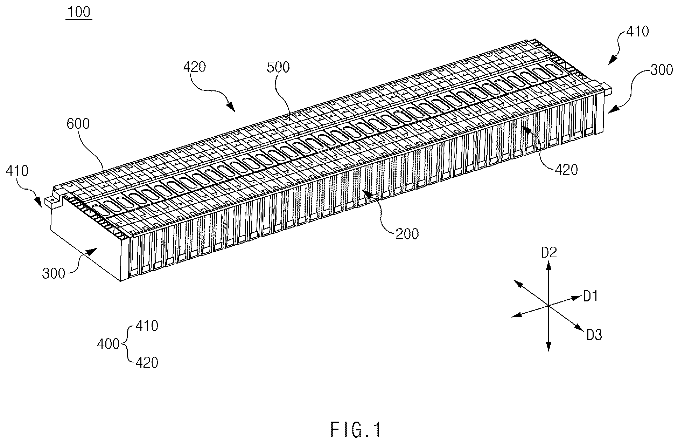

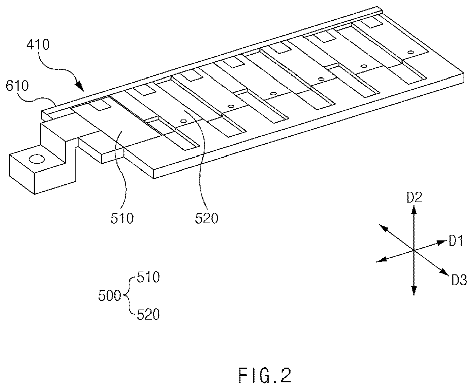

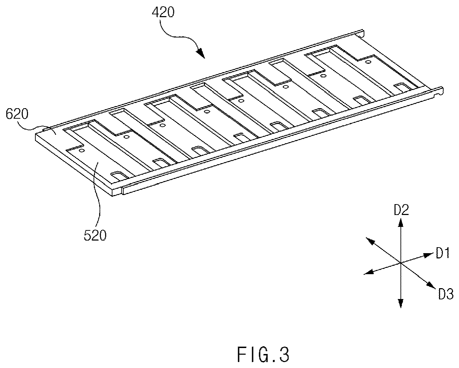

FIG. 1 is a perspective view of a battery cell stack according to an embodiment of the present disclosure. FIG. 2 is a perspective view of an outer unit sensing assembly of a sensing assembly according to an embodiment of the present disclosure. FIG. 3 is a perspective view of a middle unit sensing assembly of the sensing assembly according to an embodiment of the present disclosure.

Referring to FIGS. 1 to 3, the battery cell stack 100 may include a plurality of battery cells 200 stacked in the first direction D1 and a pair of end plates 300 disposed on opposite sides of the plurality of battery cells 200 in the first direction D1.

The battery cell stack 100 may include the sensing assembly 400 including a plurality of busbars 500 electrically connected to the plurality of battery cells 200, respectively. The sensing assembly 400 may be a component for sensing the voltages or temperatures of the plurality of battery cells 200.

The sensing assembly 400 may support the plurality of busbars 500 and may be arranged in the first direction D1. The sensing assembly 400 may include a plurality of unit sensing assemblies 410 and 420.

The plurality of unit sensing assemblies 410 and 420 may include the outer unit sensing assembly 410 and the middle unit sensing assemblies 420. The outer unit sensing assembly 410 may be a unit sensing assembly disposed at the outermost position in the first direction D1 among the plurality of unit sensing assemblies 410 and 420. The middle unit sensing assemblies 420 may be the remaining unit sensing assemblies other than the outer unit sensing assembly 410 among the plurality of unit sensing assemblies 410 and 420.

The outer unit sensing assembly 410 may include the busbars 500 and an outer sensing frame 610 supporting the busbars 500. The busbars 500 may include an outer busbar 510 and middle busbars 520.

The outer busbar 510 may electrically connect the battery cell 200 disposed at the outermost position in the first direction D1 among the plurality of battery cells 200 and the outside of the battery cell stack 100.

The middle busbars 520 may be electrically connected with the remaining battery cells 200 other than the battery cell 200 disposed at the outermost position in the first direction D1 among the plurality of battery cells 200.

Each of the middle unit sensing assemblies 420 may include middle busbars 520 and a middle sensing frame 620. The above-described outer sensing frame 610 may be disposed on one side of the outermost middle sensing frame 620 in the first direction D1. The outer sensing frame 610 may be removably coupled with the outermost middle sensing frame 620. In addition, a pair of middle sensing frames 620 adjacent to each other in the first direction D1 may be coupled so as to be removable from each other.

Accordingly, one middle unit sensing assembly 420 among the plurality of middle unit sensing assemblies 420 may be removably coupled with another middle unit sensing assembly 420 or the outer unit sensing assembly 410.

According to this structure, the length of the sensing assembly 400 may be adjusted by adding or excluding any one middle unit sensing assembly 420, and thus the length of the battery cell stack 100 may be adjusted.

The length-adjustable battery cell stack 100, the size of which is adjusted to a desired size, may be mounted in a battery housing (not illustrated), and the capacity of the battery cells 200 may be varied. Accordingly, the usability of the battery cell stack 100 may be improved.

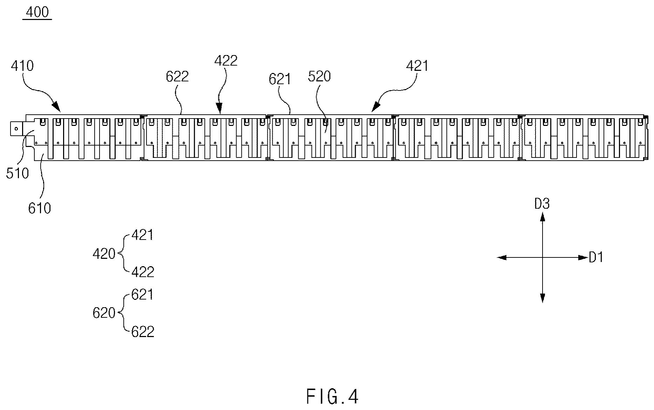

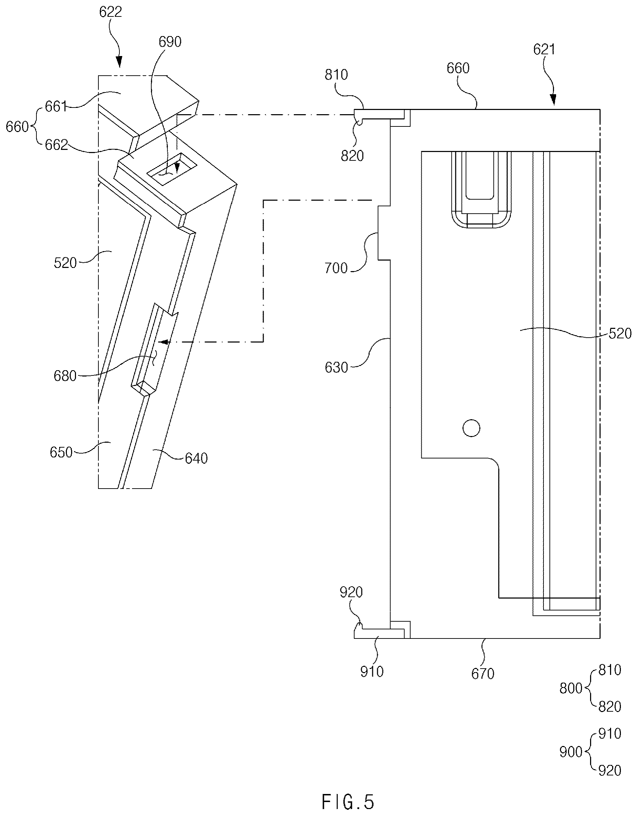

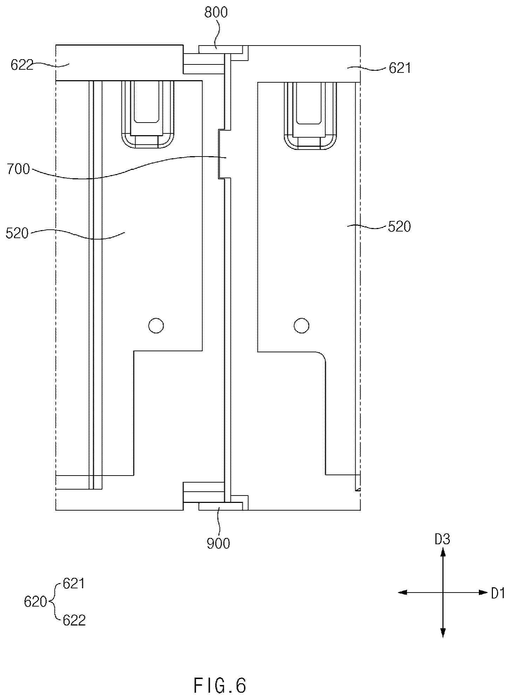

FIG. 4 is a plan view of the sensing assembly according to an embodiment of the present disclosure. FIG. 5 is a view of a first middle sensing frame and a second middle sensing frame according to an embodiment of the present disclosure. FIG. 6 is a view illustrating the first middle sensing frame and the second middle sensing frame coupled to each other according to an embodiment of the present disclosure.

Referring to FIGS. 4 to 6, the plurality of middle unit sensing assemblies 420 may be provided. The middle unit sensing assemblies 420 may include a first middle unit sensing assembly 421 and a second middle unit sensing assembly 422 disposed on one side of the first middle unit sensing assembly 421 in the first direction D1.

The first middle unit sensing assembly 421 may include the first middle sensing frame 621, and the second middle unit sensing assembly 422 may include the second middle sensing frame 622.

The following description will be given on the basis that the second middle unit sensing assembly 422 is disposed between the outer unit sensing assembly 410 and the first middle unit sensing assembly 421 and coupled to both the outer unit sensing assembly 410 and the first middle unit sensing assembly 421. However, the present disclosure is not limited thereto. For example, one middle unit sensing assembly 420 may be provided, and the sensing assembly 400 may include only the one middle unit sensing assembly 420 and the outer unit sensing assembly 410.

Each of the first middle sensing frame 621 and second middle sensing frame 622 may include a first peripheral surface 630 that faces toward one side in the first direction D1 and a second peripheral surface 640 that is disposed on the opposite side to the first peripheral surface 630 and that faces toward an opposite side in the first direction D1.

Each of the first middle sensing frame 621 and second middle sensing frame 622 may include a support surface 650 that is connected with the second peripheral surface 640 and that faces toward one side in the second direction D2 and first and second side surfaces 660 and 670 that face toward opposite sides in the third direction D3 between the first peripheral surface 630 and the second peripheral surface 640.

The first side surface 660 may face toward one side in the third direction D3, and the second side surface 670 may be disposed parallel to the first side surface 660 and may face toward an opposite side in the third direction D3.

Each of the first middle sensing frame 621 and second middle sensing frame 622 may include a guide protrusion 700 protruding from the first peripheral surface 630 toward the one side in the first direction D1.

Each of the first middle sensing frame 621 and second middle sensing frame 622 may include a guide groove 680. The guide groove 680 may be formed on the area where the support surface 650 and the second peripheral surface 640 are connected and may be formed to be open toward the opposite side in the first direction D1 and the one side in the second direction D2.

The guide protrusion 700 may be formed on an area of the first peripheral surface 630 that faces toward the one side in the second direction D2. The guide protrusion 700 of the first middle sensing frame 621 may be inserted into the guide groove 680 of the second middle sensing frame 622.

The positions of the first middle sensing frame 621 and second middle sensing frame 622 may be guided by the above-described structure in a process of coupling the first middle sensing frame 621 and second middle sensing frame 622, and thus the first and second middle sensing frames 621 and 622 may be relatively easily coupled with each other.

However, the length of the guide protrusion 700 in the first direction D1 may be greater than the depth of the guide groove 680 in the first direction D1. According to this structure, the separation distance between the first peripheral surface 630 of the first middle sensing frame 621 and the second peripheral surface 640 of the second middle sensing frame 622 may be maintained. Accordingly, even though there is a difference in thickness between the battery cells 200 in the first direction D1, the positions of the unit sensing assemblies 410 and 420 may correspond to the positions of the battery cells 200.

Each of the first middle sensing frame 621 and second middle sensing frame 622 may include a first seating protrusion 800 extending from the first side surface 660 toward the one side in the first direction D1 and a second seating protrusion 900 extending from the second side surface 670 toward the one side in the first direction D1.

Each of the first middle sensing frame 621 and second middle sensing frame 622 may include a first seating groove 690 formed on an opposite area of the first side surface 660 in the first direction D1 and a second seating groove formed on an opposite area of the second side surface 670 in the first direction D1.

The first seating protrusion 800 of the first middle sensing frame 621 may be seated in the first seating groove 690 of the second middle sensing frame 622, and the second seating protrusion 900 of the first middle sensing frame 621 may be seated in the second seating groove of the second middle sensing frame 622.

In more detail, the first seating protrusion 800 may include a first seating area 810 that is connected to the first side surface 660 and that extends toward the one side in the first direction D1 and a first insertion area 820 that protrudes from the first seating area 810 toward the opposite side in the third direction D3.

The second seating protrusion 900 may include a second seating area 910 that is connected to the second side surface 670 and that extends toward the one side in the first direction D1 and a second insertion area 920 that extends from the second seating area 910 toward the one side in the third direction D3.

The first and second seating areas 810 and 910 may be disposed parallel to each other, and the first and second insertion areas 820 and 920 may protrude toward each other.

The first side surface 660 may include a first base area 661 to which the first seating protrusion 800 is connected and a first recessed area 662 that is recessed from the first base area 661 toward the opposite side in the third direction D3.

The first recessed area 662 may be formed on an opposite side of the first base area 661 in the first direction D1, and the first seating groove 690 may be formed on the first recessed area 662.

The reason why the first seating groove 690 is recessed toward the opposite side in the third direction D3 when compared to the first base area 661 may be to form a space in which the first seating protrusion 800 is seated.

The first insertion area 820 may be inserted into the first seating groove 690, and the first seating area 810 may be brought into contact with the first recessed area 662.

The second side surface 670 may include a second base area to which the second seating protrusion 900 is connected and a second recessed area that is recessed from the second base area toward the one side in the second direction D2.

The second recessed area may be formed on an opposite side of the second base area in the first direction D1, and the second seating groove may be formed on the second recessed area.

The reason why the second seating groove is recessed toward the one side in the third direction D3 when compared to the second base area may be to form a space in which the second seating protrusion 900 is seated.

The second insertion area 920 may be inserted into the second seating groove, and the second seating area 910 may be brought into contact with the second recessed area.

As the first and second seating protrusions 800 and 900 described above are inserted into the first seating groove 690 and the second seating groove, respectively, the first middle sensing frame 621 and the second middle sensing frame 622 may be completely coupled with each other.

Meanwhile, the lengths by which the first seating area 810 and the second seating area 910 protrude from the first base area 661 and the second base area toward the one side in the first direction D1 may be longer than the length of the first recessed area 662 and the length of the second recessed area in the first direction D1.

According to this structure, the separation distance between the first peripheral surface 630 of the first middle sensing frame 621 and the second peripheral surface 640 of the second middle sensing frame 622 may be maintained. Accordingly, even though there is a difference in thickness between the battery cells 200 in the first direction D1, the positions of the unit sensing assemblies 410 and 420 may correspond to the positions of the battery cells 200.

In accordance with the structure described above, the outer sensing frame 610 (refer to FIG. 2) may include an outer guide groove (not illustrated) into which the guide protrusion 700 of the middle sensing frame 620 is inserted.

In addition, the outer sensing frame 610 may include a first outer seating groove (not illustrated) in which the first seating protrusion 800 of the middle sensing frame 620 is seated and a second outer seating groove (not illustrated) in which the second seating protrusion 900 of the middle sensing frame 620 is seated.

One surface of the outer sensing frame 610 that faces the middle sensing frame 620 may correspond to the structure of the second peripheral surface 640 of the middle sensing frame 620, and the outer guide groove of the outer sensing frame 610 may also correspond to the structure of the guide groove 680 of the middle sensing frame 620. Accordingly, the description of the second peripheral surface 640 and the guide groove 680 of the middle sensing frame 620 is applied to the outer guide groove and the one surface of the outer sensing frame 610 that faces the middle sensing frame 620.

In addition, the description of the first and second side surfaces 660 and 670, the first seating groove 690, and the second seating groove of the middle sensing frame 620 is applied to a pair of outer side surfaces of the outer sensing frame 610 that face toward the opposite sides in the third direction D3 and the first outer seating groove and the second outer seating groove of the outer sensing frame 610.

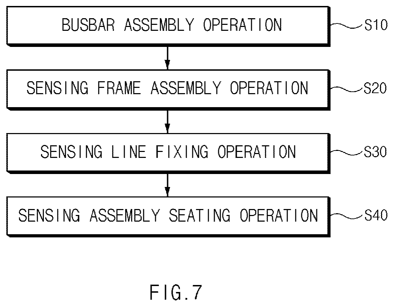

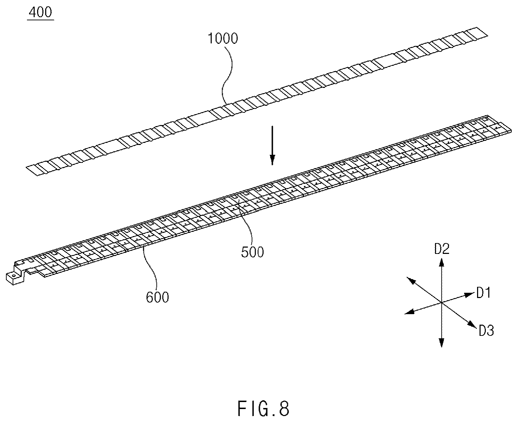

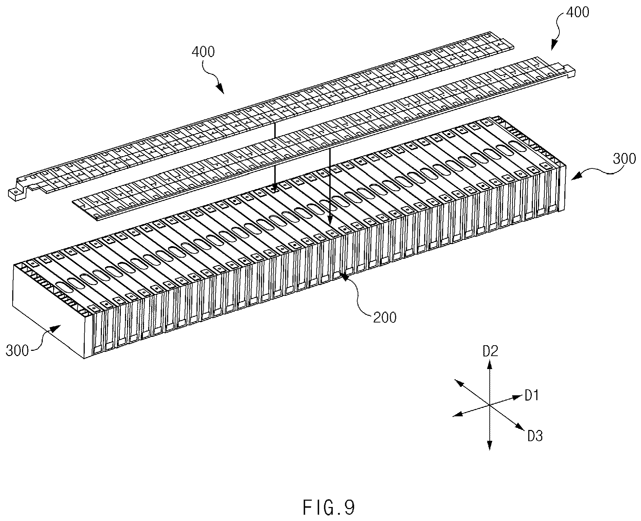

FIG. 7 is a flowchart illustrating a method for manufacturing the battery cell stack according to an embodiment of the present disclosure. FIG. 8 is a perspective view of a sensing line, bus bars, and a sensing frame for a sensing line fixing operation illustrated in FIG. 7. FIG. 9 is a perspective view of battery cells, end plates, and sensing assemblies for a sensing assembly seating operation illustrated in FIG. 7.

Referring to FIGS. 7 to 9, the manufacturing method of the battery cell stack 100 (refer to FIG. 1) may include a busbar assembly operation S10, a sensing frame assembly operation S20, a sensing line fixing operation S30, and a sensing assembly seating operation S40.

The busbar assembly operation S10 may be an operation of preparing a plurality of unit sensing assemblies 410 and 420 in which the busbars 500 are assembled to the sensing frame 600. The busbars 500 may include the outer busbar 510 (refer to FIG. 2) and the middle busbars 520, and the sensing frame 600 may include the outer sensing frame 610 and the middle sensing frame 620.

The sensing frame assembly operation S20 may be an operation of coupling unit sensing assemblies 410 and 420 adjacent to each other in the first direction D1 among the plurality of unit sensing assemblies 410 and 420 after the busbar assembly operation S10.

The plurality of unit sensing assemblies 410 and 420 may include one outer unit sensing assembly 410 and at least one middle unit sensing assembly 420. That is, in the sensing frame assembly operation S20, the one outer unit sensing assembly 410 and the at least one middle unit sensing assembly 420 may all be coupled.

The sensing line fixing operation S30 may be an operation of manufacturing the sensing assembly 400 by fixing a sensing line 1000 to the plurality of unit sensing assemblies 410 and 420 after the sensing frame assembly operation S20.

The sensing line 1000 may be a component that extends in the first direction D1 to sense the voltage of each of the plurality of battery cells 200. The sensing line 1000 may be attached with the plurality of busbars 500. The sensing line 1000 may be welded to the plurality of busbars 500 by an ultrasonic wave or a laser. However, the connection of the sensing line 1000 with the plurality of busbars 500 is not limited thereto, and the sensing line 1000 may be fixed to the plurality of busbars 500 by other methods.

When the sensing line 1000 is fixed to the plurality of unit sensing assemblies 410 and 420 in the sensing line fixing operation S30, the sensing assembly 400 including the sensing line 1000, the busbars 500, and the sensing assembly 600 may be completely manufactured.

The sensing assembly seating operation S40 may be an operation of seating the sensing assembly 400 on the battery cells 200 stacked in the first direction D1 after the sensing line fixing operation S30.

A pair of sensing assemblies 400 may be provided. The pair of sensing assemblies 400 may be arranged parallel to each other such that the outer unit sensing assemblies 410 of the pair of sensing assemblies 400 are provided on the opposite sides in the first direction D1.

In the sensing assembly seating operation S40, the pair of sensing assemblies 400 may be seated on one side of the battery cells 200 that faces in the second direction D2, and the busbars 500 may be electrically connected with the battery cells 200, respectively.

According to the manufacturing process, in the sensing frame assembly operation S20, the assembly of the unit sensing assemblies 410 and 420 may be facilitated, and the length of the sensing assembly 400 may be adjusted. Thus, the productivity and usability of the battery cell stack 100 may be improved.

According to the present disclosure, the length of the sensing assembly is adjustable. Accordingly, the capacity of the battery cell stack mounted in the battery housing may be varied, and thus the usability of the battery cell stack may be improved.

Furthermore, according to the present disclosure, the guide protrusion of the middle sensing frame may be inserted into the guide groove or the outer guide groove, and thus the coupling of the middle sensing frames or the coupling of the middle sensing frame and the outer sensing frame may be facilitated.

Moreover, according to the present disclosure, the first and second seating protrusions of the middle sensing frame may be inserted into the first and second seating grooves or the first and second outer seating grooves, and thus the coupling force between the middle sensing frames or the coupling force between the middle sensing frame and the outer sensing frame may be strong.

In addition, according to the present disclosure, the unit sensing assemblies may be coupled with each other while maintaining a certain interval therebetween, and thus the positions of the unit sensing assemblies may correspond to the positions of the battery cells even though there is a difference in thickness between the battery cells.

Hereinabove, although the present disclosure has been described with reference to exemplary embodiments and the accompanying drawings, the present disclosure is not limited thereto, but may be variously modified and altered by those skilled in the art to which the present disclosure pertains without departing from the spirit and scope of the present disclosure claimed in the following claims. Therefore, the exemplary embodiments of the present disclosure are provided to explain the spirit and scope of the present disclosure, but not to limit them, so that the spirit and scope of the present disclosure is not limited by the embodiments. The scope of the present disclosure should be construed on the basis of the accompanying claims, and all the technical ideas within the scope equivalent to the claims should be included in the scope of the present disclosure.

## Claims

1. A sensing assembly comprising:
a plurality of busbars; and
a plurality of sensing frames arranged along a first direction and configured to support the plurality of busbars,
wherein the sensing frames include a middle sensing frame and an outer sensing frame disposed on a first side of the middle sensing frame along the first direction, and
wherein the middle sensing frame includes:
a first peripheral surface configured to face toward one side in the first direction;
a second peripheral surface disposed on an opposite side to the first peripheral surface and configured to face toward an opposite side in the first direction;
a support surface connected with the second peripheral surface and configured to face toward one side in a second direction crossing the first direction;
a guide protrusion configured to protrude from the first peripheral surface toward the one side in the first direction; and
a guide groove disposed on an area where the support surface and the second peripheral surface are connected, the guide groove being open toward the opposite side in the first direction and the one side in the second direction.

2. The sensing assembly of claim 1, wherein the middle sensing frame includes a first middle sensing frame and a second middle sensing frame disposed side by side along the first direction, and
wherein a guide protrusion of the first middle sensing frame is inserted into a guide groove of the second middle sensing frame.

3. The sensing assembly of claim 1 or 2, wherein the middle sensing frame includes:
a first side surface configured to face toward one side in a third direction crossing the first direction and the second direction;
a first seating protrusion including a first seating area configured to extend from the first side surface toward the one side in the first direction and a first insertion area configured to protrude from the first seating area toward an opposite side in the third direction; and
a first seating groove disposed on an opposite area of the first side surface.

4. The sensing assembly of claim 3, wherein the middle sensing frame includes a first middle sensing frame and a second middle sensing frame disposed side by side along the first direction, and
wherein a first seating protrusion of the first middle sensing frame is seated in a first seating groove of the second middle sensing frame.

5. The sensing assembly of claim 3 or 4, wherein the first side surface includes:
a first base area to which the first seating protrusion is connected; and
a first recessed area recessed from the first base area toward the opposite side in the third direction, the first recessed area including the first seating groove disposed thereon.

6. The sensing assembly of any one of claims 3 to 5, wherein the middle sensing frame includes:
a second side surface disposed parallel to the first side surface and configured to face toward the opposite side in the third direction;
a second seating protrusion including a second seating area configured to extend from the second side surface toward the one side in the first direction and a second insertion area configured to protrude from the second seating area toward the one side in the third direction; and
a second seating groove disposed on an opposite area of the second side surface.

7. The sensing assembly of claim 6, wherein the middle sensing frame includes a first middle sensing frame and a second middle sensing frame disposed side by side along the first direction, and
wherein a second seating protrusion of the first middle sensing frame is seated in a second seating groove of the second middle sensing frame.

8. The sensing assembly of claim 6 or 7, wherein the second side surface includes:
a second base area to which the second seating protrusion is connected; and
a second recessed area recessed from the second base area toward the one side in the third direction, the second recessed area including the second seating groove disposed thereon.

9. The sensing assembly of any one of claims 6 to 8, wherein the outer sensing frame includes a first outer seating groove in which the first seating protrusion is seated and a second outer seating groove in which the second seating protrusion is seated.

10. The sensing assembly of any one of claims 1 to 9, wherein the outer sensing frame includes an outer guide groove into which the guide protrusion is inserted.

11. A method for manufacturing a battery cell stack, the method comprising:
a busbar assembly operation of preparing a plurality of unit sensing assemblies in which a busbar is assembled to a sensing frame;
a sensing frame assembly operation of coupling unit sensing assemblies adjacent to each other in a first direction among the plurality of unit sensing assemblies after the busbar assembly operation;
a sensing line fixing operation of manufacturing a sensing assembly by fixing a sensing line to the plurality of unit sensing assemblies after the sensing frame assembly operation; and
a sensing assembly seating operation of seating the sensing assembly on stacked battery cells after the sensing line fixing operation.
